# EUROPEAN PATENT SPECIFICATION

(11) **EP 4 214 756 B1**
(45) Date of publication and mention of the grant of the patent: **21.08.2024**
(21) Application number: 21706421.1
(22) Date of filing: 20.01.2021
(51) Int. Cl.: H10B 41/49, H01L 29/423

(54) **METHOD OF FORMING A DEVICE WITH PLANAR SPLIT GATE NON-VOLATILE MEMORY CELLS, HIGH VOLTAGE DEVICES AND FINFET LOGIC DEVICES**
VERFAHREN ZUR HERSTELLUNG EINER VORRICHTUNG MIT PLANAREN NICHTFLÜCHTIGEN SPLIT-GATE-SPEICHERZELLEN, HOCHSPANNUNGSVORRICHTUNGEN UND FINFET-LOGIKVORRICHTUNGEN
PROCÉDÉ DE FORMATION D'UN DISPOSITIF À CELLULES DE MÉMOIRE NON VOLATILE PLANAIRES À GRILLE DIVISÉE, DE DISPOSITIFS À HAUTE TENSION ET DE DISPOSITIFS LOGIQUES DU TYPE FINFET

(30) Priority: 21.09.2020 CN 202010993707; 19.01.2021 US 202117151944
(43) Date of publication of application: 26.07.2023
(73) Proprietor: Silicon Storage Technology, Inc., San Jose, CA 95134 (US)
(72) Inventor: WANG, Chunming, Shanghai 201203 (CN); SONG, Guo Xiang, Shanghai 201203 (CN); XING, Leo, Shanghai 201203 (CN); SUN, Jack, Shanghai 201203 (CN); LIU, Xian, Sunnyvale, California 94087 (US); DO, Nhan, Saratoga, California 95070 (US)
(74) Representative: Betten & Resch
(86) International application number: PCT/US2021/014244
(87) International publication number: WO 2022/060402

(56) References cited:
- US-A1- 2017 345 840
- US-A1- 2019 172 942
- US-A1- 2020 176 459

## Description

### PRIORITY CLAIM

This patent application claims priority to Chinese Patent Application No. 202010993707.2, filed on September 21, 2020, entitled "Method Of Forming A Device With Planar Split Gate Non-volatile Memory Cells, High Voltage Devices And FINFET Logic Device," and U.S. Patent Application No. 17/151,944, filed on January 19, 2021, entitled "Method Of Forming A Device With Planar Split Gate Non-volatile Memory Cells, High Voltage Devices And FINFET Logic Device."

### TECHNICAL FIELD

The present invention relates to a method of forming a device having non-volatile memory cells, high voltage devices and FINFET logic devices.

### BACKGROUND OF THE INVENTION

Split gate non-volatile flash memory cells having a select gate, a floating gate, a control gate and an erase gate are well known in the art. See for example U.S. patents 6,747,310 and 7,868,375. Split gate non-volatile flash memory cells having a select gate, a floating gate and an erase gate are also well known in the art. See for example U.S. patents 7,315,056 and 8,711,636. It is also known to form logic devices (i.e., low voltage and/or high voltage logic devices) on the same silicon chip, and in doing so share some of the processing steps for forming portions of both the memory cells and logic devices (e.g. forming gates for both memory cells and logic devices using the same polysilicon deposition process). However, other processing steps in forming the memory cells can adversely affect previously fabricated logic devices, and vice versa, so it often can be difficult and complex to form both types of devices on the same wafer.

To solve problems with reduced channel widths by shrinking lithography size, FinFET types of structures have been proposed for memory cell structures. In a FinFET type of structure, a fin shaped member of semiconductor material connects the source to the drain regions. The fin shaped member has a top surface and two side surfaces. Current from the source to the drain regions can then flow along the top surface as well as the two side surfaces of the fin shaped member. Thus, the effective width of the channel region is increased, thereby increasing the current flow. However, the effective width of the channel region is increased without sacrificing more semiconductor real estate by "folding" the channel region into two side surfaces, thereby reducing the "footprint" of the channel region. Non-volatile memory cells using such FinFETs have been disclosed. Some examples of prior art FinFET non-volatile memory structures include U.S. Pat. Nos. 7,423,310, 7,410,913, 8,461,640 and 9,985,042, and U.S. Patent Application 16/724,010. What these prior art references do not contemplate is a FinFET type configuration for logic devices formed on the same wafer substrate as both non-volatile memory cells and high voltage transistor devices, both of a non-FinFET type configuration, with improved fabrication techniques.

U.S. Pat. Nos. 9,972,630 and 10,249,631 disclose memory devices with FinFET type logic devices and non-FinFET memory cells. However, these patents fail to contemplate the contemporaneous formation of high voltage transistor devices of a non-FinFET type configuration.

US 20190172942 A1 discloses memory device including a memory cell, a logic device and a high voltage device formed on the same semiconductor substrate. Portions of the upper surface of the substrate under the memory cell and the high voltage device are recessed relative to the upper surface portion of the substrate under the logic device. The memory cell includes a polysilicon floating gate disposed over a first portion of a channel region of the substrate, a polysilicon word line gate disposed over a second portion of the channel region, a polysilicon erase gate disposed over a source region of the substrate, and a metal control gate disposed over the floating gate and insulated from the floating gate by a composite insulation layer that includes a high-K dielectric. The logic device includes a metal gate disposed over the substrate. The high voltage device includes a polysilicon gate disposed over the substrate.

### BRIEF SUMMARY OF THE INVENTION

The present invention is set out in the independent claims. Preferred embodiments are defined in the dependent claims.

The aforementioned problems and needs are addressed by a method of forming a device that includes:
providing a silicon substrate with an upper surface and having first, second and third areas;
recessing the upper surface in the first and second areas of the substrate, but not in the third area of the substrate;
forming a first polysilicon layer over and insulated from the upper surface in the first and second areas;
forming first trenches through the first polysilicon layer and into the silicon substrate in the first and second areas but not in the third area, using at least a first silicon etch; filling the first trenches with insulation material;
after the filling of the first trenches, forming second trenches into the silicon substrate in the third area using at least a second silicon etch to form an upwardly extending fin of the silicon substrate having a pair of side surfaces extending up and terminating at a top surface;
after the forming of the fin, forming a pair of blocks of material over the first polysilicon layer in the first area;
removing portions of the first polysilicon layer in the first area to form a pair of floating gates of the first polysilicon layer each disposed under one of the pair of blocks of material;
performing a first implantation to form a first source region in the silicon substrate in the first area between the pair of floating gates;
forming a second polysilicon layer over the silicon substrate in the first, second and third areas;
removing portions of the second polysilicon layer to form:
   a first polysilicon block of the second polysilicon layer disposed over and insulated from the first source region in the first area,
   a second polysilicon block of the second polysilicon layer disposed over and insulated from the silicon substrate and adjacent one of the pair of floating gates in the first area,
   a third polysilicon block of the second polysilicon layer disposed over and insulated from the silicon substrate and adjacent another one of the pair of floating gates in the first area,
   a fourth polysilicon block of the second polysilicon layer disposed over and insulated from the silicon substrate in the second area, and
   a fifth polysilicon block of the second polysilicon layer disposed over and insulated from the pair of side surfaces and the top surface of the silicon fin in the third area;
performing one or more implantations to form:
   a first drain region in the first area of the substrate adjacent the second polysilicon block,
   a second drain region in the first area of the substrate adjacent the third polysilicon block,
   a second source region in the second area of the substrate adjacent the fourth polysilicon block,
   a third drain region in the second area of the substrate adjacent the fourth polysilicon block,
   a third source region in the fin adjacent the fifth polysilicon block, and
   a fourth drain region in the fin adjacent the fifth polysilicon block;
removing the fifth polysilicon block;
forming a layer of high K material along the pair of side surfaces and the top surface of the fin in the third area; and
forming a block of metal material on the layer of high K material in the third area so that the block of metal extends along and is insulated from the pair of side surfaces and the top surface of the fin.

Other objects and features of the present invention will become apparent by a review of the specification, claims and appended figures.

### BRIEF DESCRIPTION OF THE DRAWINGS

Figs. 1A-15A are side cross sectional views showing steps in forming non-volatile memory cells in a memory cell area of a semiconductor substrate.
Figs. 1B-15B are side cross sectional views showing steps in forming high voltage devices in a HV device area of the semiconductor substrate.
Figs. 1C-15C are side cross sectional views showing steps in forming logic devices in a logic device area of the semiconductor substrate.
Fig. 16 is a side cross sectional view of the memory cells in the memory cell area.
Fig. 17 is a side cross sectional view of the high voltage devices in the HV device area.
Figs. 18-19 are side cross sectional views of the logic devices in the logic device area.
Figs. 20A-21A are side cross sectional views showing steps in forming non-volatile memory cells in a memory cell area of a semiconductor substrate according to an alternate embodiment.
Figs. 20B-21B are side cross sectional views showing steps in forming high voltage devices in a HV device area of the semiconductor substrate according to the alternate embodiment.
Figs. 20C-21C are side cross sectional views showing steps in forming logic devices in a logic device area of the semiconductor substrate according to the alternate embodiment.

### DETAILED DESCRIPTION OF THE INVENTION

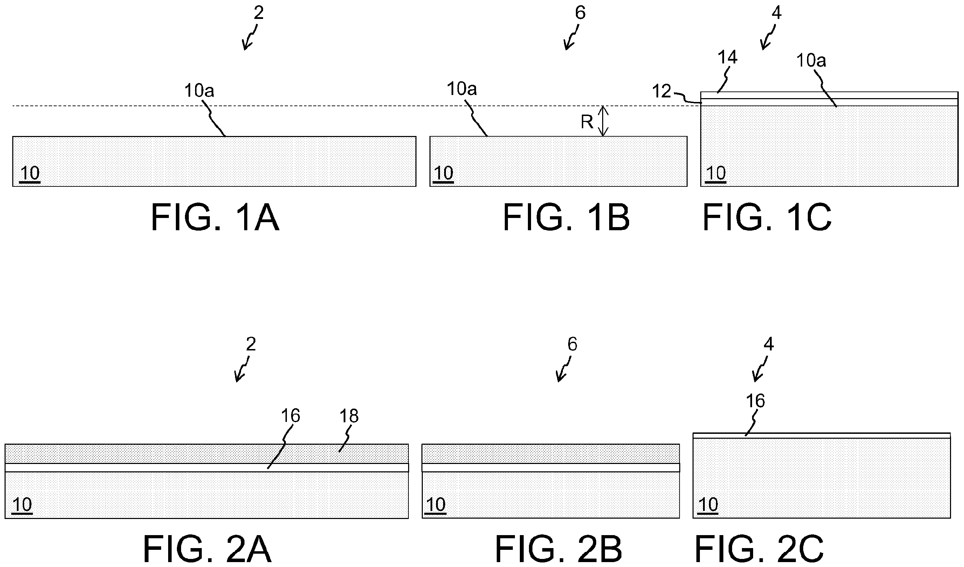

Referring to Figures 1A-15A, 1B-15B and 1C-15C, there are shown side cross-sectional views of the steps in the process of making pairs of memory cells in a memory cell area 2 (first area) of a semiconductor wafer substrate (also referred to as substrate) 10 (see Figs. 1A-15A), high voltage transistor devices in a HV device area 6 (second area) of the substrate 10 (see Figs. 1B-15B), and logic devices in a logic device area 4 (third area) of the substrate 10 (see Figs. 1C-15C). The process begins by forming a layer of silicon dioxide (also referred to as oxide) 12 on the planar surface 10a of a substrate 10, which substrate 10 may be formed of P type single crystalline silicon. Oxide layer 12 can be formed by deposition or by thermal oxidation. A layer of silicon nitride 14 (also referred to as nitride layer 14) is formed on oxide layer 12. A photolithography masking process is then used to pattern the nitride layer 14 and oxide layer 12 (i.e. selectively remove some portions of the layers but not others). The photolithography masking process includes coating photoresist material on the nitride layer 14, which is followed by exposing and developing the photoresist to remove the photoresist material from the memory cell and HV device areas 2/6 while maintaining the photoresist in the logic device area 4. Nitride and oxide etches are then used to remove the exposed nitride and oxide layers 14/12 from the memory cell and HV device areas 2/6 leaving the upper surface 10a of the substrate 10 exposed in the memory cell and HV device areas 2/6 (the photoresist protects these layers from the etches in the logic device area 4). After the remaining photoresist is removed from the logic device area 4, a silicon oxidation alone, or a silicon oxidation in combination with a silicon etch, is used to recess the exposed upper surface 10a of the substrate 10 in the memory cell and HV device areas 2/6. For example, the silicon oxidation can be a thermal oxidation that consumes the silicon at the substrate's upper surface 10a. Oxide and nitride layers 12/14 protect the logic device area 4 from this oxidation/etch. An oxide etch is then used to remove the oxide created by the thermal oxidation. The resulting structure is shown in Figs. 1A-1C, where the upper surface 10a of the substrate 10 in the HV/memory cell areas 6/2 is recessed below the surface 10a of the substrate 10 in the logic device area 4 by a recess amount R. A non-limiting example of the amount of recess R can include approximately 20-70 nm.

Nitride and oxide layers 14/12 are removed from the logic device area 4 (e.g. by one or more etches), leaving the surface 10a of the substrate 10 exposed. The upper surface 10a of the substrate 10 at this stage is stepped, where the portions of the upper surface 10a of the substrate 10 in the memory cell and HV device areas 2/6 are recessed (i.e., lower) relative to the portion of the upper surface 10a of the substrate 10 in the logic device area 4 by recess amount R. An oxide (insulation material) layer 16 is then formed on the surface 10a of the substrate 10 in all three areas 2/4/6 (e.g., by deposition or thermal oxide), followed by the formation of a polysilicon (also referred to as poly) layer 18 (first polysilicon layer) by poly deposition on oxide layer 16. A photolithography masking process is used to cover the structure with photoresist and remove the photoresist from the logic device area 4. A polysilicon etch is then used to remove the poly layer 18 from the logic device area 4. The resulting structure is shown in Figs. 2A-2C (after photoresist removal). This poly layer 18 will eventually be used to form the floating gates of memory cells in memory cell area 2.

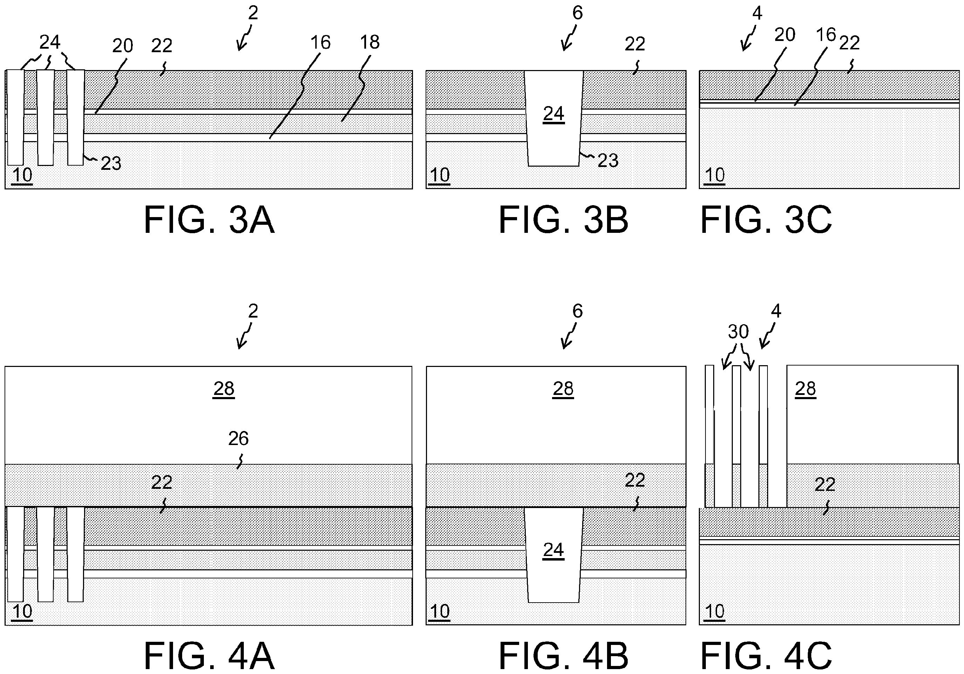

An oxide layer 20 is formed on the poly layer 18 in the memory cell and HV device areas 2/6 and on the oxide layer 16 in the logic device area 4, and a nitride layer 22 is formed on the oxide layer 20. A photolithography masking step is used to cover the structure with photoresist and then selectively remove portions of the photoresist to leave select portions of the underlying nitride layer 22 exposed. One or more etches are then performed in those select areas to form trenches 23 that extend through nitride layer 22, oxide layer 20, poly layer 18, oxide layer 16 and into the substrate 10 in memory cell and HV device areas 2/6. After photoresist removal, the structure is covered in a layer of oxide (i.e., shallow trench isolation (STI) oxide) 24, filling the trenches 23 with oxide 24. The structure is then planarized (e.g., by chemical mechanical polish - CMP) to expose the top surface of nitride layer 22. The resulting structure is shown in Figs. 3A-3C.

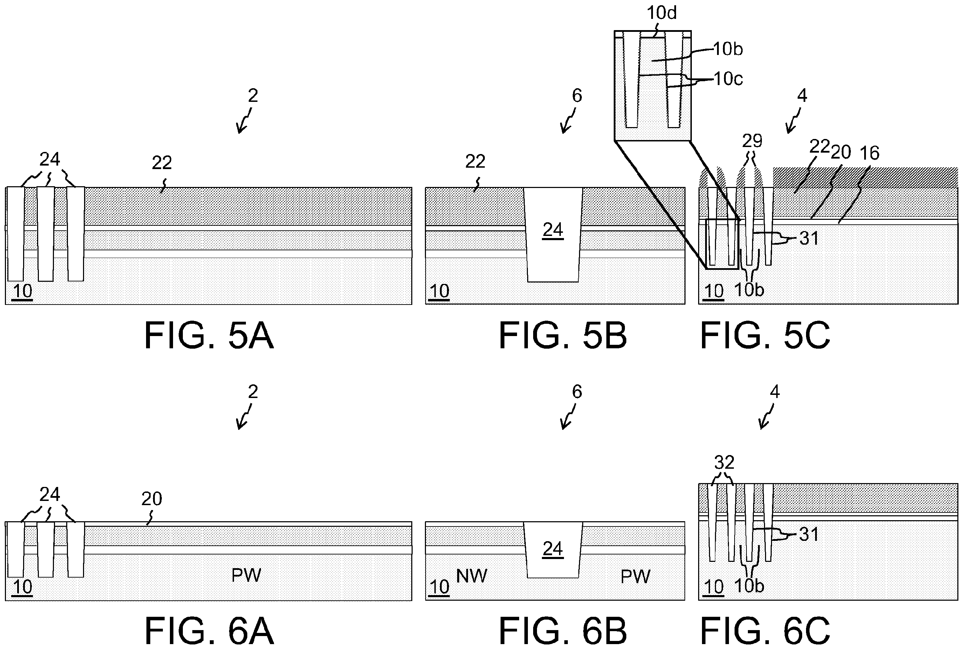

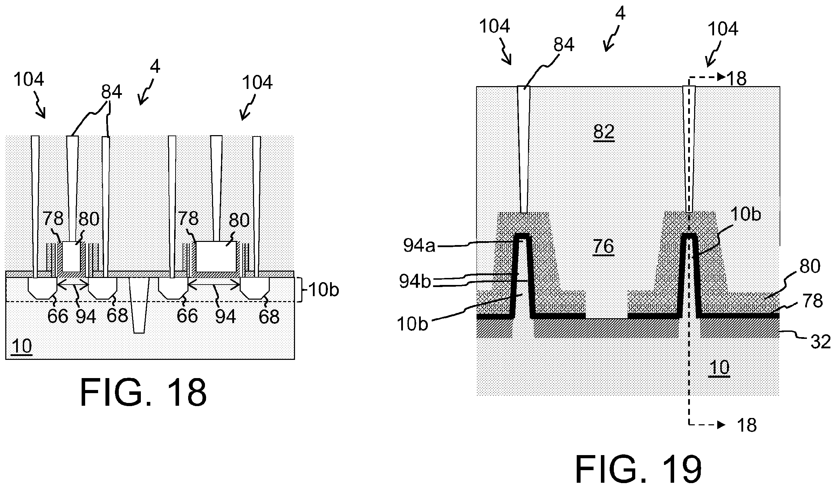

A layer of material 26 (e.g., polysilicon) is formed on nitride layer 22. The layer of material 26 is patterned by forming photoresist 28, selectively removing strips of the photoresist 28 in the logic device area 4, and removing the underlying exposed portions of the layer 26 to form trenches 30 in the layer 26 in the logic device area 4 that extend down to and expose the underlying nitride layer 22, as shown in Figs. 4A-4C. After photoresist removal, spacers 29 are then formed in the trenches 30. Formation of spacers is well known in the art, and involves the deposition of a material over the contour of a structure, followed by an anisotropic etch process, whereby the material is removed from horizontal surfaces of the structure, while the material remains largely intact on vertically oriented surfaces of the structure (often with a rounded upper surface). In the present case, the spacers 29 are formed along the sidewalls of trenches 30, and are preferably formed of oxide or nitride. Next, the remaining portions of layer 26 are removed by an etch. Next, the structure is covered with photoresist, which is exposed and developed to remove the photoresist from the logic device area 4. A nitride etch is then used to remove the exposed portions of nitride layer 22 between the spacers 29 in the logic device area, followed by an oxide etch to remove exposed portions of oxide layers 20 and 16 in the logic device area 4 and oxide layer 20 in the memory cell and HV device areas 2/6. A silicon etch is then used to recess the exposed surface of the substrate 10 in the logic device area 4, forming trenches 31 that extend into substrate 10 with fins 10b of the silicon substrate between the trenches 31. Each fin 10b is an upwardly extending member having a pair of side surfaces 10c extending up and terminating at a top surface 10d as explained further below with respect to Fig. 19. The resulting structure is shown in Figs. 5A-5C (after photoresist removal).

The spacers 29 are removed by an etch. Oxide deposition and CMP are used to fill the spaces between the fins 10b with STI oxide 32. The HV device area can have PMOS and NMOS regions. Photoresist is formed over the structure, and removed from the PMOS regions of HV device area 6. Implantations are then performed into the substrate 10 to form N wells (NW). Etches are then performed to recess the oxide 24, and remove nitride layer 22, in the HV device area 6. After photoresist removal, photoresist is formed over the structure, and removed from the NMOS regions of the HV device area 6 and from the memory cell area 2. Implantations are then performed into the substrate 10 to form P wells (PW). Etches are then performed to recess the oxide 24, and remove nitride layer 22, in the memory cell area 2. The resulting structure is shown in Figs. 6A-6C (after photoresist removal).

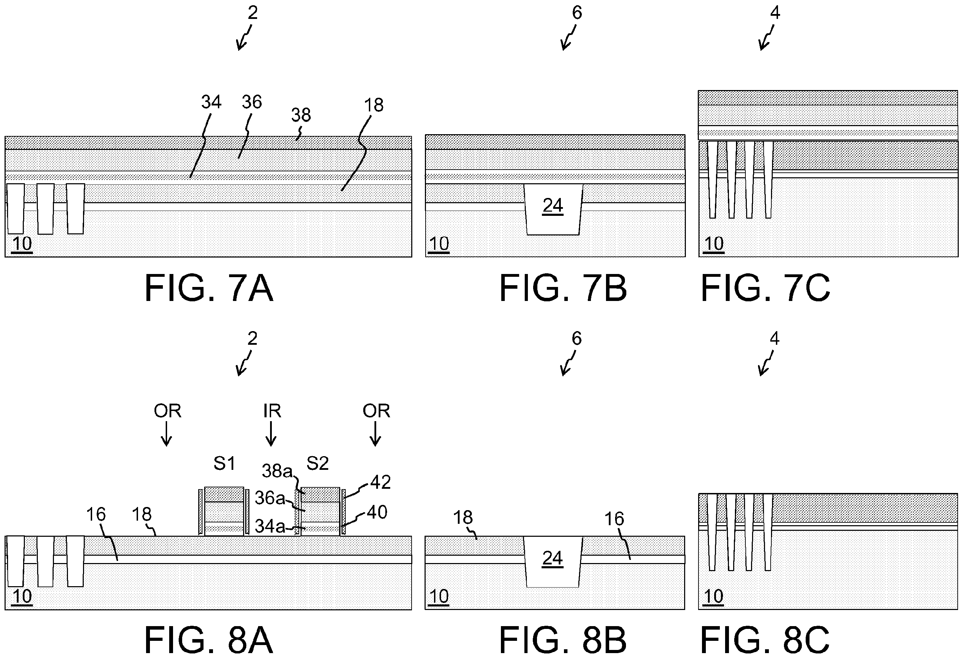

An oxide etch is used to remove oxide layer 20 from the memory cell and HV device areas 2/6 (and lowers the upper surface of oxide 24 in these areas). A layer of insulation 34, preferably containing three sublayers of oxide, nitride and oxide (e.g., an ONO layer) is formed over the structure. A poly layer 36 is formed on the ONO layer 34 by a second polysilicon deposition. A hard mask layer (e.g., nitride or other appropriate insulation material) 38 is formed on poly layer 36. The resulting structure is shown in Figs. 7A-7C. Photoresist is formed over the structure, and partially removed to fully expose the logic device area 4, fully expose the HV device area 6, and expose portions of the memory cell area 2, leaving portions of the hard mask layer 38 exposed. A nitride etch is used to remove the exposed portions of hard mask layer 38, exposing portions of poly layer 36. A poly etch is used to remove the exposed portions of poly layer 36, exposing portions of the insulation layer 34. An etch is used to remove the exposed portions of insulation layer 34, exposing portions of the poly layer 18. After photoresist removal, ON (oxide and nitride) spacers 40/42 are formed by oxide deposition, nitride deposition, and then nitride anisotropic etch and oxide anisotropic etch. The resulting structure is shown in Figs. 8A-8C. As shown in Fig. 8A, pairs of stack structures S1 and S2 are formed in the memory cell area 2, which include blocks of hard mask material 38a remaining from hard mask layer 38, on blocks of polysilicon 36a remaining from poly layer 36, on blocks of insulation 34a remaining from insulation layer 34, with oxide and nitride spacers 40/42 along the sides of stack structures S1 and S2. For each pair of stack structures S1/S2, the area between the stack structures S1 and S2 is referred to herein as the inner region IR, and the areas on the opposite sides of stack structures S1 and S2 are referred to herein as the outer regions OR.

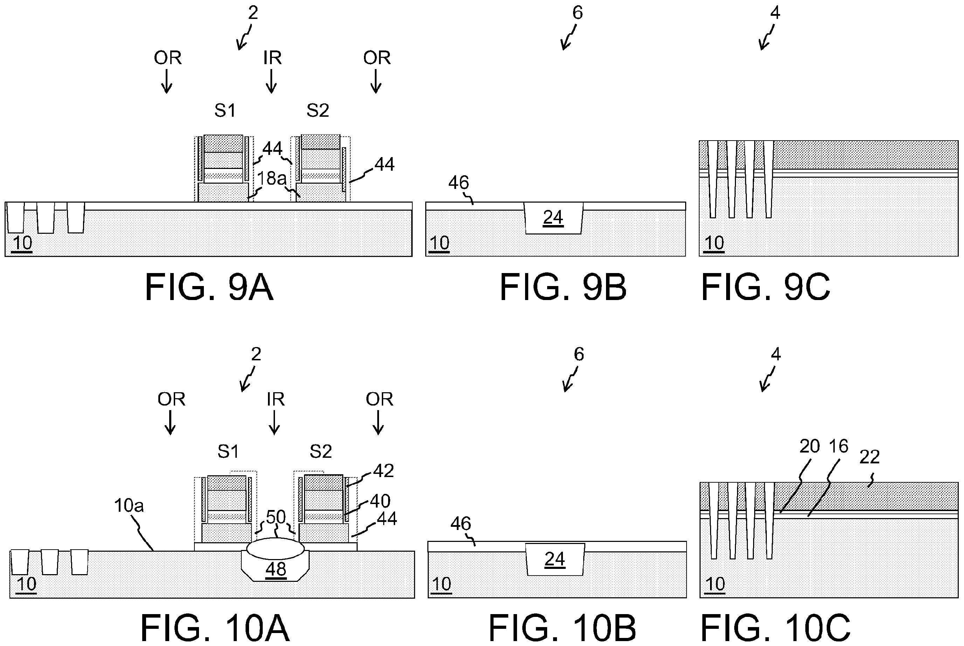

A poly etch is then used to remove the exposed portions of poly layer 18 in the memory cell and HV device areas 2/6 (i.e. all portions except those protected by stack structures S1 and S2). Oxide spacers 44 are then formed on the sides of stack structures S1 and S2 by oxide deposition and anisotropic etch. Stack structures S1 and S2 now further include poly blocks 18a remaining from poly layer 18, at a lower portion thereof. Photoresist is formed over the structure and removed only from the HV device area 6. An optional implantation can be performed into the substrate 10 in the HV device area 6. An oxide etch is then used to remove oxide layer 16 from the HV device area 6. An oxide layer 46 is formed on the exposed substrate surface 10a in the HV device area 6 (e.g., by thermal oxidation or deposition), having a thickness appropriate for the operation of the HV devices to be formed in this area. The resulting structure is shown in Figs. 9A-9C (after photoresist removal).

The structure is then covered with photoresist, which is selectively removed to expose the inner region IR between pairs of stack structures S1 and S2 in the memory cell area 2. An implantation is then performed to form source regions 48 in the memory cell area 2 in the substrate 10 between each of the pairs of stack structures S1 and S2. An oxide etch is then used to remove the oxide spacers 44 on inner sidewalls of the stack structures S1 and S2 (i.e. those sidewalls facing each other in the inner region IR). A layer of oxide (tunnel oxide) 50 is formed on the inner sidewalls of the stack structures S 1 and S2 and on the substrate surface 10a between the stack structures S1 and S2 (e.g. by thermal oxidation and/or oxide deposition), having a thickness suitable for electron tunneling. Thermal oxidation and the high dopant concentration of the source regions 48 can cause oxide layer 50 to be thicker on the substrate surface 10a. The structure is covered by photoresist, which is removed from the outer regions OR in the memory cell area 2. An implantation is performed in the substrate 10 in the outer regions OR (referred to as the word line voltage implant). An oxide etch is used to remove oxide layer 16 from the outer regions OR in the memory cell area 2. The resulting structure is shown in Figs. 10A-10C (after photoresist removal).

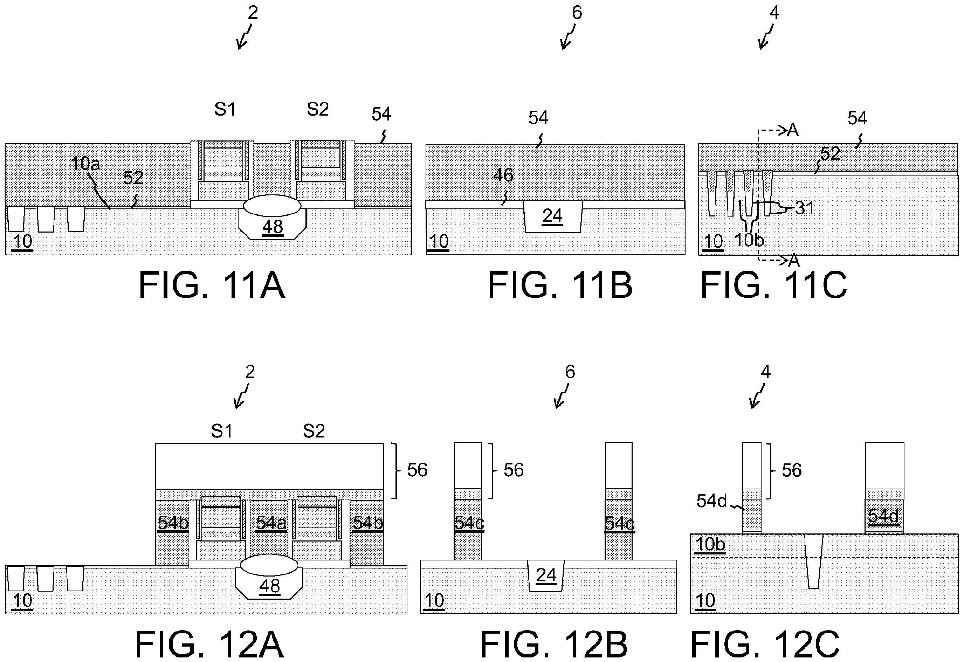

Photoresist is formed on the structure, and removed from the logic device area 4. An etch is used to remove nitride layer 22 from the logic device area 4. An implantation is performed to create a well in the substrate 10 in the logic device area 4. An oxide etch is used to remove oxide layers 20 and 16 from the logic device area 4, and to recess the oxide 32 in the trenches 31 that surround the fins 10b. After photoresist removal, a dielectric (insulation) layer 52 is formed on the exposed surface 10a of the substrate in the memory cell and logic device areas 2/4, and along the sides of the fins 10b in the logic device area 4. Dielectric layer 52 also becomes part of the oxide layer 46 in the HV device area 6. Dielectric layer 52 can an oxide, an oxynitride, or other suitable insulating material. A layer of polysilicon 54 (second polysilicon layer) is then deposited on the structure including around the sides of fins 10b in the logic device area 4. CMP and etch back processes are used to reduce the thickness of the polysilicon layer 54 (i.e., so that the upper surface of poly layer 54 is even with, or below, the tops of the stack structures S1/S2 in the memory cell area 2). The resulting structure is shown in Figs. 11A-11C.

A hard mask layer 56 is formed on the structure, which can be a single layer of material or multiple layers of material (two layers are shown in the figures). The hard mask layer 56 is patterned using one or more photolithography processes, leaving portions of the hard mask layer 56 exposed. The exposed portions of the hard mask layer 56 are removed by one or more etches, leaving portions of the poly layer 54 exposed. The exposed portions of the poly layer 54 are removed by one or more etches, where those portions of poly layer 54 underneath and protected by the remaining portions of the hard mask 56 are protected from the one or more etches and remain. The resulting structure is shown in Figs. 12A-12C, where Fig. 12C is a cross sectional view of the fin 10b orthogonal to the views of Figs. 1C-11C, along the line A-A in Fig. 11C. The patterning of the hard mask and poly layer could be performed in two stages. For example, a first hard mask etch could be performed in the memory cell and HV device areas 2/6, and in a partial area in the logic device area 4, followed by separate second hard mark etch for the partial area in the logic device area 4 only. After photoresist removal, a separate poly etch is then performed. The resulting structure has first blocks of poly 54a remaining from poly layer 54 each disposed over one of the source regions 48, second and third blocks of poly 54b remaining from poly layer 54 each disposed in one of the outer regions OR adjacent one of the stack structures S1/S2, fourth blocks of poly 54c remaining from poly layer 54 each disposed in the HV device area 6, and fifth blocks of poly 54d remaining from poly layer 54 each disposed in the logic device area 4. Each of the fifth blocks of poly 54d wrap around the fin 10b.

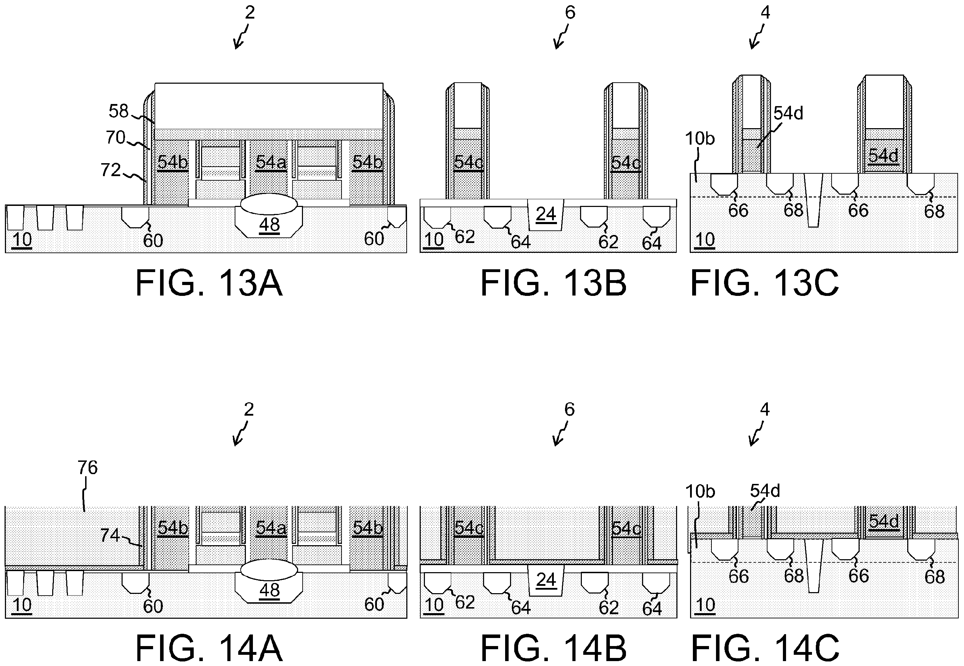

Insulation spacers (e.g. nitride) 58 are formed on the sides of the structures by deposition and anisotropic etch. A series of masking steps and implantations are performed to form drain regions 60 in the substrate 10 adjacent the poly blocks 54b in the memory cell area 2, source and drain regions 62 and 64 in the substrate 10 adjacent the poly blocks 54c in the HV device area 6, and source and drain regions 66 and 68 in the substrate 10 adjacent the poly blocks 54d. The formation of source and drain regions 66 and 68 in the logic device area 4 can include removing portions of the fins 10b adjacent poly blocks 54d, and replacing them with epitaxially grown material, where source and drain regions 66 and 68 are epitaxially grown material portions of the fins 10b. Optionally, drain regions 60 in the memory cell area 2, and/or source and drain regions 62/64 in the HV device area 6, can also be replaced with epitaxially grown material in a similar manner. Additional oxide spacers 70 and nitride spacers 72 can be formed along nitride spacers 58. The resulting structure is shown in Figs. 13A-13C.

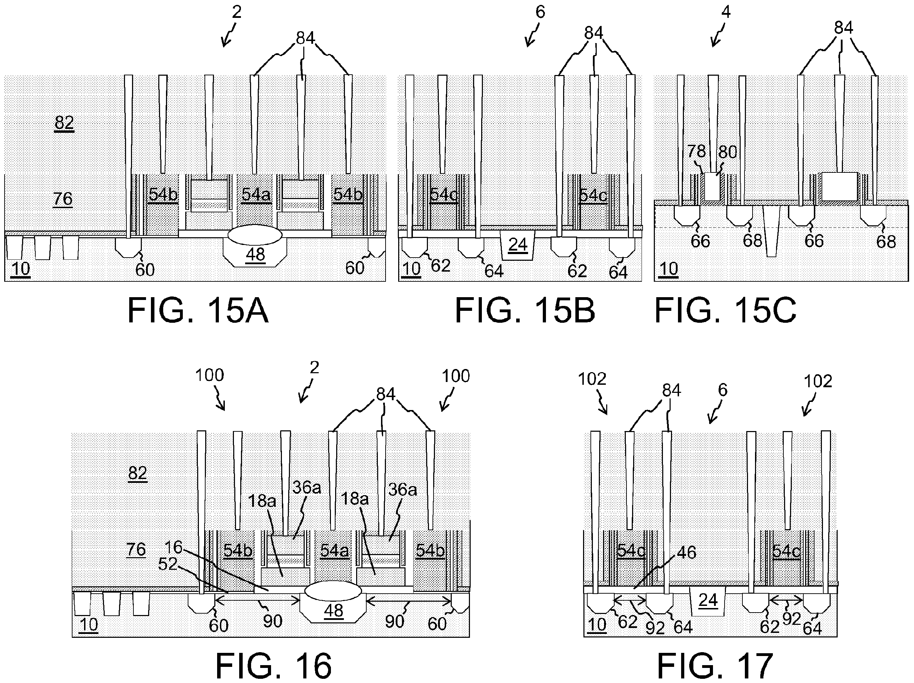

An etch stop layer of material 74 is formed over the structure. A thick layer of insulation material (ILD) 76 is formed over the structure. Chemical mechanical polishes and etches are then performed to lower the ILD layer 76, remove hard mask layer 56, and expose poly blocks 54a, 54b, 54c and 54d (e.g., stop CMP after poly blocks 54a-54d are exposed), as shown in Figs. 14A-14C. Etches are used to remove poly blocks 54d (exposing dielectric layer 52) and to remove exposed dielectric layer 52 from the logic device area 4. A layer of high K material 78 (i.e. having a dielectric constant K greater than that of silicon dioxide, such as HfO2, ZrO2, TiO2, Ta2O5, or other adequate materials) is formed on the structure. A layer of metal material is formed over the structure. A CMP is used to remove the metal material and high K material layer except for blocks of metal 80 disposed over, and insulated from, the fin 10b by the layer of high K material 78. ILD insulation layer 82 is formed over the structure, and contact holes are formed in the ILD and other insulation layers to expose the various source and drain regions, poly blocks and metal blocks. The contact holes are then filled with a contact material, such as metal, to form electrical contacts 84. The final structure is shown in Figs. 15A-15C.

Fig. 16 is a cross sectional view showing a pair of non-volatile memory cells 100 formed in the memory cell area 2. Each pair of non-volatile memory cells 100 includes a (first) source region 48 and two (first and second) drain regions 60 that define planar channel regions 90 in the substrate 10 there between. For each non-volatile memory cell 100, a floating gate, formed by poly block 18a is disposed over and controls a first portion of the channel region 90, and a word line (select) gate formed by poly block 54b is disposed over and controls a second portion of the channel region 90. A control gate, formed from polysilicon block 36a, is disposed over the floating gate formed by poly block 18a, and an erase gate formed by poly block 54a is disposed over the source region 48. The non-volatile memory cells 100 are formed in pairs end to end, which each memory cell pair sharing a common drain region 60, and adjacent pairs of non-volatile memory cells 100 sharing a common erase gate formed by poly block 54a and source region 48. The dielectric layer 52 under the word line gates formed by poly block 54b is preferably thinner than the oxide layer 16 under the floating gates formed by poly block 18a, for better word line gate performance.

Fig. 17 includes a cross sectional view of HV (high voltage) devices 102 formed in the HV device area 6. Each HV device 102 includes a (second) source region 62 and a (third) drain region 64 that define a planar channel region 92 in the substrate 10 there between. The HV gate formed by poly block 54c is disposed over and controls the conductivity of the planar channel region 92. The HV gate formed by poly block 54c is insulated from the substrate by oxide layer 46, which can have a different thickness than oxide layer 16 (for the floating gates formed by poly block 18a) and dielectric layer 52 (for the word lines gates formed by poly block 54b) because it is formed separately, for improved performance of the HV devices 102.

Figs. 18 and 19 are cross sectional views of logic devices 104 formed in the logic device area 4. Each logic device 104 includes a (third) source region 66 and a (fourth) drain region 68 that define a channel region 94 in the fin 10b there between. As best shown in Fig. 19, channel region 94 includes a top surface portion 94a extending along the top of the fin 10b, and side surface portions 94b extending along the sides of the fin 10b. The logic gate 80 wraps around the fin 10b (i.e., the logic gate formed from blocks of metal 80 is disposed over the top surface portion of the channel region 94, particularly over top surface portion 94a, and laterally adjacent to the side surface portions 94b, for controlling the conductivity of the channel region 94).

While only two non-volatile memory cells 100, two HV devices 102 and two logic devices 104 are shown in the figures, one skilled in the art would appreciate that many devices of each type are simultaneously formed in their respective areas.

The above described memory device method and resulting structure provide many advantages, including the advantages of high operational performance and ease of manufacturing of planar non-volatile memory cells 100 (i.e. non-volatile memory cells 100 that are formed on a planar region of the substrate 10 and have a planar channel region 90) and planar HV devices 102 (i.e., devices that are formed on a planar region of the substrate 10 and have a planar channel region 92) with the advantages of advanced combinations of embedded logic and memory devices where the logic devices 104 are condensed, non-planar logic devices (i.e., logic devices that are formed on, and surrounding, fins 10b and have channel regions 94 which are non-planar). The FinFET transistor architecture of the logic devices 104 provides enhanced channel control with a tri-gate configuration and enables further scaling of the transistor dimensions.

Another advantage is that the upper surface 10a of substrate 10 is recessed in the memory cell and HV device areas 2/6 relative to the logic device area 4. Specifically, the planar upper surface 10a of the substrate 10 which constitute the channel regions in the memory cell and HV device areas 2/6 have a height that is recessed below the tops of the fins 10b in the logic device area 4 by a recess amount R as shown in Figs. 1A-1C, which accommodates the higher gate stack thickness and topology of the memory cell and HV devices 100/102 relative to the logic devices 104. Additionally, common processing in the logic device area 4 and the memory cell and HV device areas 2/6 is facilitated. For example, having fins 10b in the logic device area 4 rising above the height of the substrate surface in the memory cell area simplifies the common formation steps of blocks of poly layer 54, hard mask layer 56, and spacers 58/70/72. Similarly, common implantation steps can be used to form the memory cell drain regions 60, HV device source/drain regions 62/64 and logic device source/drain regions 66/68. Further, the erase gates formed by poly block 54a, word line gates formed by poly block 54b, HV gates formed by poly block 54c and dummy poly blocks 54d are all formed using the same polysilicon deposition processing. Still another advantage is using poly blocks 54d of poly layer 54 as dummy blocks, which are removed and replaced with high K material and metal gates 80. This means a single polysilicon layer is used to form the erase gates formed by poly block 54a and word line gates formed by poly block 54b in the memory cell area 2, the high voltage gates formed by poly block 54c in the HV device area 6, and the dummy poly blocks 54d in the logic area 4. A majority of the process fabrication for the memory cells and HV devices (including the formation of all the poly blocks for the gates of the memory cells and HV devices) is performed before the formation of the logic gates, which reduces processing impacts on the CMOS baseline. The STI insulation for the memory cell and HV device areas 2/6 are formed before the fins 10b are formed in the logic device area 4, which means the depths of STI extending into the substrate can vary between the memory cell and HV device areas 2/6 and the logic device area (i.e., the trenches 23 can extend deeper into the substrate 10 than do the trenches 31, and vice versa).

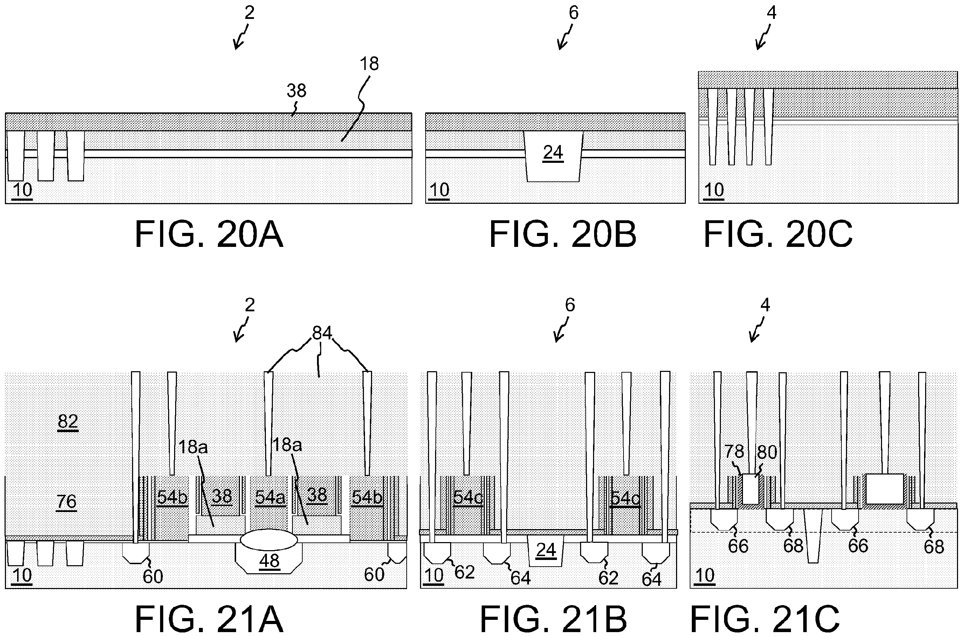

Figs. 20A-20C and 21A-21C illustrate an alternate embodiment, which begins with the structure of Figs. 6A-6C. In this alternate embodiment, the steps described above with respect to Figs. 7A-7C are performed, except the formations of insulation layer 34 and poly layer 36 are omitted, so that hard mask layer 38 is formed directly on the poly layer 18, as shown in Figs. 20A-20C. The remaining processing steps are performed as described above except for any steps that were directed to insulation layer 34 and poly layer 36, resulting in the final structure shown in Figs. 21A-21C. The only significant difference in the final structure in this first alternate embodiment is that there are no control gates (blocks of material from poly layer 36) over the floating gates formed by poly block 18a in the memory cell area 2. Instead, each memory cell only includes only three gates (floating gate formed by poly block 18a, word line gate formed by poly block 54b, and erase gate formed by poly block 54a). In this embodiment, the blocks of material over the floating gates are blocks of nitride layer 38. The omission of the control gate would allow the height of the memory cells to be further reduced.

It is to be understood that the present invention is not limited to the embodiment(s) described above and illustrated herein. For example, references to the present invention herein are not intended to limit the scope of any claim or claim term, but instead merely make reference to one or more features that may be covered by one or more claims. Materials, processes and numerical examples described above are exemplary only, and should not be deemed to limit the claims. Further, as is apparent from the claims and specification, not all method steps need be performed in the exact order illustrated or claimed, but rather in any order (unless there is an explicitly recited limitation on any order) that allows the proper formation of the memory cells and logic devices of the present invention. Lastly, single layers of material could be formed as multiple layers of such or similar materials, and vice versa.

It should be noted that, as used herein, the terms "over" and "on" both inclusively include "directly on" (no intermediate materials, elements or space disposed there between) and "indirectly on" (intermediate materials, elements or space disposed there between). Likewise, the term "adjacent" includes "directly adjacent" (no intermediate materials, elements or space disposed there between) and "indirectly adjacent" (intermediate materials, elements or space disposed there between), "mounted to" includes "directly mounted to" (no intermediate materials, elements or space disposed there between) and "indirectly mounted to" (intermediate materials, elements or spaced disposed there between), and "electrically coupled" includes "directly electrically coupled to" (no intermediate materials or elements there between that electrically connect the elements together) and "indirectly electrically coupled to" (intermediate materials or elements there between that electrically connect the elements together). For example, forming an element "over a substrate" can include forming the element directly on the substrate with no intermediate materials/elements there between, as well as forming the element indirectly on the substrate with one or more intermediate materials/elements there between.

## Claims

1. A method of forming a device, comprising:
providing a silicon substrate (10) with an upper surface (10a) and having first, second and third areas (2, 6, 4);
recessing the upper surface in the first and second areas of the substrate, but not in the third area (4) of the substrate;
forming a first polysilicon layer (18) over and insulated from the upper surface in the first and second areas (2, 6);
forming first trenches (23) through the first polysilicon layer and into the silicon substrate in the first and second areas but not in the third area, using at least a first silicon etch;
filling the first trenches with insulation material (24);
after the filling of the first trenches, forming second trenches (31) into the silicon substrate in the third area using at least a second silicon etch to form an upwardly extending fin (10b) of the silicon substrate having a pair of side surfaces (10c) extending up and terminating at a top surface (10d);
after the forming of the fin, forming a pair of blocks of material (36a) over the first polysilicon layer in the first area;
removing portions of the first polysilicon layer in the first area to form a pair of floating gates (18a) of the first polysilicon layer each disposed under one of the pair of blocks of material;
performing a first implantation to form a first source region (48) in the silicon substrate in the first area between the pair of floating gates;
forming a second polysilicon layer (54) over the silicon substrate in the first, second and third areas;
removing portions of the second polysilicon layer to form:
a first polysilicon block (54a) of the second polysilicon layer disposed over and insulated from the first source region in the first area,
a second polysilicon block (54b) of the second polysilicon layer disposed over and insulated from the silicon substrate and adjacent one of the pair of floating gates in the first area,
a third polysilicon block (54b) of the second polysilicon layer disposed over and insulated from the silicon substrate and adjacent another one of the pair of floating gates in the first area,
a fourth polysilicon block (54c) of the second polysilicon layer disposed over and insulated from the silicon substrate in the second area, and
a fifth polysilicon block (54d) of the second polysilicon layer disposed over and insulated from the pair of side surfaces and the top surface of the silicon fin in the third area;
performing one or more implantations to form:
a first drain region (60) in the first area of the substrate adjacent the second polysilicon block,
a second drain region (60) in the first area of the substrate adjacent the third polysilicon block,
a second source region (62) in the second area of the substrate adjacent the fourth polysilicon block,
a third drain region (64) in the second area of the substrate adjacent the fourth polysilicon block,
a third source region (66) in the fin adjacent the fifth polysilicon block, and
a fourth drain region (68) in the fin adjacent the fifth polysilicon block;
removing the fifth polysilicon block;
forming a layer of high K material (78) along the pair of side surfaces and the top surface of the fin in the third area; and
forming a block of metal material (80) on the layer of high K material in the third area so that the block of metal extends along and is insulated from the pair of side surfaces and the top surface of the fin.

2. The method of claim 1, wherein the pair of blocks of material are formed of polysilicon and are insulated from the pair of floating gates.

3. The method of claim 2, wherein the pair of blocks of material are insulated from the pair of floating gates by an oxide-nitride-oxide layer (34).

4. The method of claim 1, wherein the pair of blocks of material are formed of an insulation material.

5. The method of claim 1, the forming of the second trenches comprises:
forming a layer of material (26) over the upper surface in the third area;
forming third trenches (30) in the layer of material;
forming spacers of material (29) in the third trenches;
removing the layer of material; and
performing the second silicon etch in portions of the silicon substrate between the spacers of material.

6. The method of claim 1, wherein the forming of the third source region and the fourth drain region comprises:
before removing the fifth polysilicon block, epitaxially growing material on the fin adjacent to the fifth polysilicon block, wherein the third source region and the fourth drain regions are formed in the epitaxially grown material.

7. The method of claim 1, wherein the second and third polysilicon blocks are insulated from the upper surface of the substrate by insulation material (52) having a thickness that is less than a thickness of insulation material (16) insulating the floating gates from the upper surface.

8. The method of claim 1, wherein the fourth polysilicon block is insulated from the upper surface of the substrate by insulation material (46) having a thickness that is different than a thickness of insulation material (16) insulating the floating gates from the upper surface.

9. The method of claim 1, wherein the first trenches extend deeper into the substrate than do the second trenches.

10. The method of claim 1, wherein the second trenches extend deeper into the substrate than do the first trenches.

## Patentansprüche

1. Verfahren zum Ausbilden einer Vorrichtung, umfassend:
Bereitstellen eines Siliciumsubstrats (10) mit einer oberen Oberfläche (10a) und das einen ersten, einen zweiten und einen dritten Bereich (2, 6, 4) aufweist;
Aussparen der oberen Oberfläche in dem ersten und dem zweiten Bereich des Substrats, jedoch nicht in dem dritten Bereich (4) des Substrats;
Ausbilden einer ersten Polysiliciumschicht (18) über der oberen Oberfläche in dem ersten und dem zweiten Bereich (2, 6) und isoliert davon;
Ausbilden von ersten Trenches (23) durch die erste Polysiliciumschicht und in das Siliciumsubstrat in dem ersten und dem zweiten Bereich, jedoch nicht in dem dritten Bereich, unter Verwendung von mindestens einer ersten Siliciumätzung;
Füllen der ersten Trenches mit Isoliermaterial (24);
nach dem Füllen der ersten Trenches, Ausbilden von zweiten Trenches (31) in das Siliciumsubstrat in dem dritten Bereich unter Verwendung von mindestens einer zweiten Siliciumätzung, um eine sich nach oben erstreckende Rippe (10b) des Siliciumsubstrats auszubilden, die ein Paar Seitenoberflächen (10c), das sich nach oben erstreckt und an einer obersten Oberfläche (10d) endet, aufweist;
nach dem Ausbilden der Rippe, Ausbilden eines Paars Blöcke aus Material (36a) über der ersten Polysiliciumschicht in dem ersten Bereich;
Entfernen von Abschnitten der ersten Polysiliciumschicht in dem ersten Bereich, um ein Paar Floating-Gates (18a) der ersten Polysiliciumschicht auszubilden, wobei jedes unter einem des Paars Blöcke aus Material angeordnet ist;
Durchführen einer ersten Implantation, um eine erste Source-Region (48) in dem Siliciumsubstrat in dem ersten Bereich zwischen dem Paar Floating-Gates auszubilden;
Ausbilden einer zweiten Polysiliciumschicht (54) über dem Siliciumsubstrat in dem ersten, dem zweiten und dem dritten Bereich;
Entfernen von Abschnitten der zweiten Polysiliciumschicht, um auszubilden:
einen ersten Polysiliciumblock (54a) der zweiten Polysiliciumschicht, der über der ersten Source-Region in dem ersten Bereich angeordnet und davon isoliert ist,
einen zweiten Polysiliciumblock (54b) der zweiten Polysiliciumschicht, der über dem Siliciumsubstrat angeordnet und davon isoliert ist und sich angrenzend an eines des Paars Floating-Gates in dem ersten Bereich befindet,
einen dritten Polysiliciumblock (54b) der zweiten Polysiliciumschicht, der über dem Siliciumsubstrat angeordnet und davon isoliert ist und sich angrenzend an ein anderes des Paars Floating-Gates in dem ersten Bereich befindet,
einen vierten Polysiliciumblock (54c) der zweiten Polysiliciumschicht, der über dem Siliciumsubstrat in dem zweiten Bereich angeordnet und davon isoliert ist, und
einen fünften Polysiliciumblock (54d) der zweiten Polysiliciumschicht, der über dem Paar Seitenoberflächen und der obersten Oberfläche der Siliciumrippe in dem dritten Bereich angeordnet und davon isoliert ist;
Durchführen einer oder mehrerer Implantationen, um auszubilden:
eine erste Drain-Region (60) in dem ersten Bereich des Substrats angrenzend an den zweiten Polysiliciumblock,
eine zweite Drain-Region (60) in dem ersten Bereich des Substrats angrenzend an den dritten Polysiliciumblock,
eine zweite Source-Region (62) in dem zweiten Bereich des Substrats angrenzend an den vierten Polysiliciumblock,
eine dritte Drain-Region (64) in dem zweiten Bereich des Substrats angrenzend an den vierten Polysiliciumblock,
eine dritte Source-Region (66) in der Rippe angrenzend an den fünften Polysiliciumblock und
eine vierte Drain-Region (68) in der Rippe angrenzend an den fünften Polysiliciumblock;
Entfernen des fünften Polysiliciumblocks;
Ausbilden einer Schicht aus High-K-Material (78) entlang des Paars Seitenoberflächen und der obersten Oberfläche der Rippe in dem dritten Bereich; und
Ausbilden eines Blocks aus Metallmaterial (80) an der Schicht aus High-K-Material in dem dritten Bereich, sodass sich der Block aus Metall entlang des Paars Seitenoberflächen und der obersten Oberfläche der Rippe erstreckt und davon isoliert ist.

2. Verfahren nach Anspruch 1, wobei das Paar Blöcke aus Material aus Polysilicium ausgebildet und von dem Paar Floating-Gates isoliert ist.

3. Verfahren nach Anspruch 2, wobei das Paar Blöcke aus Material mittels einer Oxid-Nitrid-Oxid-Schicht (34) von dem Paar Floating-Gates isoliert ist.

4. Verfahren nach Anspruch 1, wobei das Paar Blöcke aus Material aus einem Isoliermaterial ausgebildet ist.

5. Verfahren nach Anspruch 1, wobei das Ausbilden der zweiten Trenches umfasst:
Ausbilden einer Schicht aus Material (26) über der oberen Oberfläche in dem dritten Bereich;
Ausbilden von dritten Trenches (30) in der Schicht aus Material;
Ausbilden von Abstandshaltern aus Material (29) in den dritten Trenches;
Entfernen der Schicht aus Material; und
Durchführen der zweiten Siliciumätzung in Abschnitten des Siliciumsubstrats zwischen den Abstandshaltern aus Material.

6. Verfahren nach Anspruch 1, wobei das Ausbilden der dritten Source-Region und der vierten Drain-Region umfasst:
vor dem Entfernen des fünften Polysiliciumblocks, epitaktisches Aufwachsen von Material auf der Rippe angrenzend an den fünften Polysiliciumblock, wobei die dritte Source-Region und die vierte Drain-Region in dem epitaktisch aufgewachsenen Material ausgebildet sind.

7. Verfahren nach Anspruch 1, wobei der zweite und der dritte Polysiliciumblock von der oberen Oberfläche des Substrats mittels des Isoliermaterials (52) isoliert sind, das eine Dicke aufweist, die geringer als eine Dicke des Isoliermaterials (16), das die Floating-Gates von der oberen Oberfläche isoliert, ist.

8. Verfahren nach Anspruch 1, wobei der vierte Polysiliciumblock von der oberen Oberfläche des Substrats mittels des Isoliermaterials (46) isoliert ist, das eine Dicke aufweist, die sich von einer Dicke des Isoliermaterials (16), das die Floating-Gates von der oberen Oberfläche isoliert, unterscheidet.

9. Verfahren nach Anspruch 1, wobei sich die ersten Trenches tiefer in das Substrat als die zweiten Trenches erstrecken.

10. Verfahren nach Anspruch 1, wobei sich die zweiten Trenches tiefer in das Substrat als die ersten Trenches erstrecken.

## Revendications

1. Procédé de formation d'un dispositif, comprenant :
la fourniture d'un substrat de silicium (10) avec une surface supérieure (10a) et ayant de première, deuxième et troisième zones (2, 6, 4) ;
l'évidement de la surface supérieure dans les première et deuxième zones du substrat, mais pas dans la troisième zone (4) du substrat ;
la formation d'une première couche de silicium polycristallin (18) sur la surface supérieure et isolée de celle-ci dans les première et deuxième zones (2, 6) ;
la formation de premières tranchées (23) à travers la première couche de silicium polycristallin et dans le substrat de silicium dans les première et deuxième zones mais pas dans la troisième zone, au moyen d'au moins une première gravure sur silicium ;
le remplissage des premières tranchées avec un matériau isolant (24) ;
après le remplissage des premières tranchées, la formation de deuxièmes tranchées (31) dans le substrat de silicium dans la troisième zone au moyen d'au moins une deuxième gravure sur silicium afin de former une ailette (10b) du substrat de silicium s'étendant vers le haut et ayant une paire de surfaces latérales (10c) s'étendant vers le haut et se terminant au niveau d'une surface supérieure (10d) ;
après la formation de l'ailette, la formation d'une paire de blocs de matériau (36a) au-dessus de la première couche de silicium polycristallin dans la première zone ;
l'élimination de parties de la première couche de silicium polycristallin dans la première zone afin de former une paire de grilles flottantes (18a) de la première couche de silicium polycristallin, disposée chacune sous l'un des blocs de la paire de blocs de matériau ;
la réalisation d'une première implantation afin de former une première région de source (48) dans le substrat de silicium dans la première zone entre la paire de grilles flottantes ;
la formation d'une deuxième couche de silicium polycristallin (54) au-dessus du substrat de silicium dans les première, deuxième et troisième zones ;
l'élimination de parties de la deuxième couche de silicium polycristallin afin de former :
un premier bloc de silicium polycristallin (54a) de la deuxième couche de silicium polycristallin disposé au-dessus de la première région source dans la première zone et isolé de celle-ci,
un deuxième bloc de silicium polycristallin (54b) de la deuxième couche de silicium polycristallin disposé au-dessus du substrat de silicium et isolé de celui-ci, et adjacent à l'une des grilles de la paire de grilles flottantes dans la première zone,
un troisième bloc de silicium polycristallin (54b) de la deuxième couche de silicium polycristallin disposé au-dessus du substrat de silicium et isolé de celui-ci, et adjacent à une autre grille de la paire de grilles flottantes dans la première zone,
un quatrième bloc de silicium polycristallin (54c) de la deuxième couche de silicium polycristallin disposé au-dessus du substrat de silicium et isolé de celui-ci dans la deuxième zone, et
un cinquième bloc de silicium polycristallin (54d) de la deuxième couche de silicium polycristallin disposé au-dessus de la paire de surfaces latérales et de la surface supérieure de l'ailette de silicium dans la troisième zone et isolé de celles-ci ;
la réalisation d'une ou de plusieurs implantations afin de former :
une première région de drain (60) dans la première zone du substrat adjacente au deuxième bloc de silicium polycristallin,
une deuxième région de drain (60) dans la première zone du substrat adjacente au troisième bloc de silicium polycristallin,
une deuxième région de source (62) dans la deuxième zone du substrat adjacente au quatrième bloc de silicium polycristallin,
une troisième région de drain (64) dans la deuxième zone du substrat adjacente au quatrième bloc de silicium polycristallin,
une troisième région de source (66) dans l'ailette adjacente au cinquième bloc de silicium polycristallin, et
une quatrième région de drain (68) dans l'ailette adjacente au cinquième bloc de silicium polycristallin ;
l'élimination du cinquième bloc de silicium polycristallin ;
la formation d'une couche de matériau à constante K élevée (78) le long de la paire de surfaces latérales et de la surface supérieure de l'ailette dans la troisième zone ; et
la formation d'un bloc de matériau métallique (80) sur la couche de matériau à constante K élevée dans la troisième zone, de sorte que le bloc de métal s'étende le long de la paire de surfaces latérales et de la surface supérieure de l'ailette et soit isolé de celles-ci.

2. Procédé selon la revendication 1, dans lequel la paire de blocs de matériau est formée de silicium polycristallin et est isolée de la paire de grilles flottantes.

3. Procédé selon la revendication 2, dans lequel la paire de blocs de matériau est isolée de la paire de grilles flottantes par une couche oxyde-nitrure-oxyde (34).

4. Procédé selon la revendication 1, dans lequel la paire de blocs de matériau est formée d'un matériau isolant.

5. Procédé selon la revendication 1, la formation des deuxièmes tranchées comprend :
la formation d'une couche de matériau (26) au-dessus de la surface supérieure dans la troisième zone ;
la formation de troisièmes tranchées (30) dans la couche de matériau ;
la formation d'espaceurs en matériau (29) dans les troisièmes tranchées ;
l'élimination de la couche de matériau ; et
la réalisation de la deuxième gravure sur silicium dans des parties du substrat de silicium entre les espaceurs en matériau.

6. Procédé selon la revendication 1, dans lequel la formation de la troisième région de source et de la quatrième région de drain comprend :
avant l'élimination du cinquième bloc de silicium polycristallin, la croissance par épitaxie d'un matériau sur l'ailette adjacente au cinquième bloc de silicium polycristallin, la troisième région de source et les quatrièmes régions de drain étant formées dans le matériau que l'on a fait croître par épitaxie.

7. Procédé selon la revendication 1, dans lequel les deuxième et troisième blocs de silicium polycristallin sont isolés de la surface supérieure du substrat par un matériau isolant (52) ayant une épaisseur qui est inférieure à l'épaisseur de matériau isolant (16) isolant les grilles flottantes de la surface supérieure.

8. Procédé selon la revendication 1, dans lequel le quatrième bloc de silicium polycristallin est isolé de la surface supérieure du substrat par un matériau isolant (46) ayant une épaisseur qui est différente de l'épaisseur de matériau isolant (16) isolant les grilles flottantes de la surface supérieure.

9. Procédé selon la revendication 1, dans lequel les premières tranchées s'étendent plus profondément dans le substrat que les deuxièmes tranchées.

10. Procédé selon la revendication 1, dans lequel les deuxièmes tranchées s'étendent plus profondément dans le substrat que les premières tranchées.
